Europäisches Patentamt

European Patent Office

Office européen des brevets

(11) Veröffentlichungsnummer: 0 169 403
A2

# (12) EUROPÄISCHE PATENTANMELDUNG

(21) Anmeldenummer: 85107984.8

(22) Anmeldetag: 27.06.85

(51) Int. Cl.⁴: **H 05 K 5/06**
//H01G1/10

(30) Priorität: 26.07.84 DE 3427657

(43) Veröffentlichungstag der Anmeldung:
29.01.86 Patentblatt 86/5

(84) Benannte Vertragsstaaten:
DE FR GB IT

(71) Anmelder: Siemens Aktiengesellschaft
Berlin und München Wittelsbacherplatz 2
D-8000 München 2(DE)

(72) Erfinder: Böld, Walter, Dr. rer. nat.
Gandershoferstrasse 8
D-8403 Bad Abbach(DE)

(72) Erfinder: Kessler, Hartmut, Dipl.-Ing.
Kurt-Schumacher-Strasse 5 b
D-8400 Regensburg(DE)

(72) Erfinder: Schmid, Hermann, Dipl.-Ing. (FH)
Blumenstrasse 36
D-8411 Reifenthal(DE)

(54) Umhülltes elektrisches Bauelement und Verfahren zu seiner Herstellung.

(57) Das elektrische Bauelement (1) is vollständig oder teilweise von einer aus zwei Schichten (11, 12 bzw. 13) bestehenden mechanisch festen, feuchtedichten, wärmebeständigen, chemikalien resistenten und isolierenden Umhüllung aus ausgehärtetem Kunststoff, insbesondere Epoxidharz, umgeben, wobei zwischen der relativ dünnen ersten Schicht (11) und der zweiten Schicht (12 bzw. 13) eine durch gemeinsame Aushärtung der Kunststoffe beider Schichten gebildete Übergangszone (14) vorhanden ist.

Siemens Aktiengesellschaft
Berlin und München

Unser Zeichen
VPA 84 P 1540 E

0169403

## Umhülltes elektrisches Bauelement und Verfahren zu seiner Herstellung

Die Erfindung betrifft ein elektrisches Bauelement, das mit einer aus zwei Schichten bestehenden, mechanisch festen, feuchtedichten, wärmebeständigen, chemikalienresistenten und isolierenden Umhüllung aus ausgehärteten Kunststoffen vollständig oder teilweise umgeben ist.

Elektrische Bauelemente im Sinne der vorliegenden Erfindung sind insbesondere regenerierende Kondensatoren mit Kunststoffdielektrikum in Schicht- oder Wickelbauweise, ferner andere Bauelemente, wie z.B. keramische Kondensatoren, Widerstände, Kaltleiter, Heißleiter, Varistoren, aber auch Dioden, Transistoren und ganze Baugruppen, beispielsweise sogenannte integrierte Schaltungen auf Halbleiterbasis. Alle diese Bauelemente sind hinreichend bekannt.

Elektrische Bauelemente oder Baugruppen müssen zum Schutz gegen Umwelteinflüsse (hohe Luftfeuchtigkeit, Betauung) und gegen aggressive Löt- und Waschmittel, die während des Einlötens in Leiterplatten einwirken können, sowie zum Schutz gegen die Berührung spannungsführender anderer Bauteile oder Leiterbahnen in zunehmendem Umfang ganz oder teilweise mit einer Umhüllung versehen werden.

Die Umhüllung muß u.a. resistent gegen die verwendeten Chemikalien sein, einen hohen elektrischen Isolationswiderstand haben, wärmebeständig sein, einen geringen Feuchtediffusionskoeffizienten aufweisen, auftretenden mechanischen Beanspruchungen widerstehen und gut am elektrischen Bauelement haften, dessen Oberfläche sowohl

Bck 1 Kth / 24.07.1984

Kunststoffe oder Keramik, als auch Metalle enthält.
Diese Umhüllung soll aus Kostengründen möglichst in einem
Arbeitsgang aufbringbar sein.

In der DE-AS 10 72 663 ist eine Mehrschichtisolation auf
Gießharzbasis für elektrische Bauteile beschrieben, die
aus einer dünnen Epoxidharzschicht besteht, die sich infolge der mit einem bei der Vergußtemperatur niedrig
viskosen Epoxidharz vorgenommenen Imprägnierung auf den
elektrischen Bauteilen gebildet hat, und aus einer darauf
aufgebrachten Gießharzumhüllung aus gefülltem Epoxidgießharz besteht, wobei auf diese Gießharzumhüllung eine
kriechstromfeste dünne Schicht auf Gießharzbasis aufgebracht ist.

In der DE-OS 25 00 789 ist ein elektrisches Bauelement
beschrieben, das eine kompressible und elektrisch isolierende Zwischenschicht zwischen einer Fläche des elektrischen Bauelementes und einer Schutzschicht enthält,
wobei diese Zwischenschicht ein Bindemittel und einen
im Bindemittel dispergierten Füllfeststoff enthält. Diese Zwischenschicht wird durch Tauchen, Sprühen oder
Spritzen aufgetragen und ausgehärtet, damit das Bindemittel hart wird. Die äußere Schutzschicht wird dann auf
die Außenfläche der Zwischenschicht aufgebracht und ausgehärtet. Dieses Aufbringen geschieht durch Tauchen,
Gießen, Sprühen oder Spritzen. Die Aushärtung erfolgt
durch Anwendung erhöhter Temperatur.

In der DE-AS 25 34 232 sind in Epoxidharz eingebettete
oder damit umhüllte regenerierfähige Kondensatoren mit
Kunststofffolien als Dielektrikum und auf diesen aufgebrachten Metallschichten als Beläge beschrieben, bei

0169403
84 P 1540 E

denen jeweils zwischen der Oberfläche des Kondensatorkörpers und dem diesen umgebenden Gießharz eine Zwischenschicht vorgesehen ist, die aus ausgehärteten Polyurethalacken besteht. Die Herstellung solcher Kondensatoren
besteht darin, daß jeweils die Lackschicht aus Polyurethan durch Tauchen unter Vakuum aufgebracht wird und
daß anschließend das Umgeben des Kondensatorwickels mit
Epoxidharz unter Vakuum vorgenommen wird.

In der DE-PS 19 48 862 ist ein Verfahren zum Umhüllen
von elektrischen Bauelementen durch Aufbringen, Aufschmelzen und gegebenenfalls Aushärten von Isolierstoffpulver beschrieben, bei dem nur die elektrisch
leitfähigen Teile des Bauelementes umhüllt werden, in
dem Isolierstoffpulver ohne genaue Dosierung auf die
zu umhüllenden Metallteile, z.B. die Stirnkontaktschichten von Kondensatoren, aufgestreut wird, dann eine erste Erwärmung der Metallschicht mit Hochfrequenz erfolgt, deren Intensität und Dauer entsprechend eingestellt sind, dann ein definierter Teil des aufgestreuten Isolierstoffpulvers angeschmolzen wird und an dem
zu umhüllenden Metallteil anklebt, wonach das nicht mit
dem Metallteil verbundene überschüssige Isolierstoffpulver abgesaugt und das am Metall klebende Isolierstoffpulver durch eine weitere Hochfrequenzbehandlung
geschmolzen, über die Metallfläche und in geringem Maß
auf angrenzende Bereiche gleichmäßig verteilt und
gegebenenfalls ausgehärtet wird. In dieser Patentschrift
ist auch beschrieben, daß bei den bis dahin bekannten
Verfahren das ganze Bauelement mit einer Kunststoffpulverschicht überzogen wurde.

Die in der genannten Patentschrift beschriebene Teilumhüllung von Bauelementen ist überall da von Vorteil, wo es ausreicht, nur die metallführenden Teile mit einer Isolationsschicht zu umgeben, weil ein erhöhter Feuchteschutz entweder nicht erforderlich ist oder aber feuchtedichte Deckschichten auf den von Metall freien Teilen des Bauelements vorhanden sind.

In der DE-PS 25 20 130 ist ein Verfahren zum allseitigen oder teilweisen Umhüllen von stirnkontaktierten elektrischen Flachwickel- oder Schichtkondensatoren mit einer im Wirbelsinterverfahren (Fließbettverfahren) aufgebrachten Kunststoffschicht beschrieben, bei dem die Kondensatoren in einen Behälter mit dem aufgewirbelten Kunststoffpulver eingebracht und dort mittels einer Hochfrequenz-Induktionserhitzungsvorrichtung erwärmt werden, wobei die Kondensatoren derart zu den Feldlinien ausgerichtet durch das Feld der Hf-Induktionserhitzungsvorrichtung geführt werden, daß die metallisierten Flächen der Folien der Schichtkondensatoren bzw. die flachen Seiten der Flachwickelkondensatoren einen eine gewünschte Verteilung des Umhüllungsmaterials über die Oberfläche der Kondensatoren zur Folge habenden Winkel mit den Feldlinien bilden.

Dieses bekannte Verfahren wird durch das in der DE-PS 28 37 259 beschriebenen Verfahren weiterentwickelt, in dem das Niveau des Pulverbades in der Wirbelschicht periodisch angehoben und abgesenkt wird.

Es ist auch hinreichend bekannt, elektrische Bauelemente in ein Gehäuse einzusetzen und nachträglich die Hohlräume des Gehäuses zu vergießen (vgl. z.B. EP-A2 0 062 167) und es ist auch bekannt, elektrische Bauelemente in einer Form mit einem Kunststoffblock zu umgeben (DE-OS 31 46 515).

Die bisher bekannten Arten zum Umhüllen elektrischer Bauelemente, nämlich Einbau in ein Gehäuse mit nachträglichem Vergießen, Einbau in einen Kunststoffblock oder Umhüllen mit flüssiger Umhüllmasse, z.B. Epoxidharz, durch Tauchen, Lackieren, Spritzen oder Umhüllen mit vorgehärteter pulverförmiger Umhüllmasse und nachträglichem Aufschmelzen und Aushärten, werden zwar den an die Umhüllung gestellten Forderungen weitgehend gerecht, weisen jedoch noch gewisse Nachteile auf. Der Einbau in ein Gehäuse oder in einen Block ist im allgemeinen kostenintensiv und außerdem ist das Fertigungsverfahren technisch aufwendig, insbesondere bei elektrischen Bauelementen mit stark unterschiedlichen Abmessungen. Bei der Umhüllung mit flüssigen Umhüllmassen (Gießharzen) besteht grundsätzlich die Gefahr, daß an scharfen Kanten des elektrischen Bauelementes eine zu geringe Schichtdicke entsteht, während an der Unterseite des Bauelementes während der Herstellung Schichtdicken resultieren, die zur Bildung von Nasen oder zur Bildung von Tropfen führen. Beim Umhüllen mit Pulver-Umhüllmassen besteht das Problem darin, eine ausreichende Feuchtedichtigkeit und Porenfreiheit zu erreichen. Insbesondere bei elektrischen Bauelementen mit Lufteinflüssen muß daher der Umhüllvorgang mehrmals wiederholt werden.

Der vorliegenden Erfindung liegt die Aufgabe zugrunde, ein umhülltes elektrisches Bauelement der eingangs angegebenen Art anzugeben, das den Forderungen an mechanische Festigkeit, Feuchtedichtigkeit, Wärmebeständigkeit, Resistenz gegen Chemikalien, mit denen das Bauelement eventuell in Berührung kommt, und Isolation ausreichend genügt und möglichst einfach herstellbar ist.

Zur Lösung dieser Aufgabe ist das elektrische Bauelement
der eingangs genannten Art erfindungsgemäß dadurch gekennzeichnet, daß die dem Bauelement benachbarte erste
Schicht relativ dünn, d.h. 0,1 bis 1 mm, ist und aus
wärmegehärtetem Kunststoff, insbesondere Epoxidharz, besteht, daß die außen liegende zweite Schicht ebenfalls
aus wärmegehärtetem Kunststoff, insbesondere Epoxidharz
besteht, der in Form von vorgehärtetem Pulver auf die
erste SChicht vor deren Aushärtung aufgetragen ist, und
daß zwischen erster Schicht und zweiter Schicht eine
durch gemeinsame Aushärtung der Kunststoffe beider Schichten gebildete Übergangszone vorhanden ist.

Das Verfahren zum Herstellen eines umhüllten Bauelements
bei dem das Bauelement zunächst durch Tauchen, Sprühen,
Bestreichen (Rollen) mit der ersten Kunststoffschicht
versehen und darauf dann die zweite Kunststoffschicht
aufgetragen wird, ist zur Lösung der Aufgabe erfindungsgemäß daourch gekennzeichnet, daß die aufzutragende
erste Schicht erzeugt wird, indem der Kunststoff der
ersten Schicht als Monomeres oder als Lösung eingesetzt wird, wobei die Viskosität gerade so gering ist,
daß daran das Pulver des Kunststoffes der zweiten
Schicht klebt (haftet), jedoch ein Abtropfen nicht eintritt, und daß die aufzutragende zweite Schicht erzeugt wird, indem vorgehärtetes Pulver des Kunststoffes der zweiten Schicht aufgestäubt oder im Fließbettverfahren auf die vorgesehenen Oberflächenteile der ersten Schicht aufgetragen wird, und daß danach beide
Kunststoffschichten in einem Arbeitsgang gemeinsam vollständig ausgehärtet werden.

0169403

Am Gegenstand der Erfindung, nämlich an dem umhüllten ·elektrischen Bauelement, sind die gegenständlichen Merkmale feststellbar. So kann die Dicke der ersten Schicht festgestellt werden, auch an der zweiten Schicht ist erkennbar, ob sie durch Auftrag eines Pulvers vorgehärteten Materials erzeugt ist, und es ist schließlich im Schliffbild auch die durch gemeinsame Härtung erzielte Übergangszone feststellbar.

Bei der Herstellung eines umhüllten elektrischen Bauelementes wird so vorgegangen, daß das Bauelement zunächst mit einer aushärtbaren, relativ flüssigen Umhüllmasse an den gewünschten Stellen umgeben wird, z.B. durch Tauchen, Sprühen, Bestreichen (Rollen) usw. Der Begriff "relativ flüssig" bedeutet, daß ein aushärtbares Harz als Monomeres oder als Lösung eingesetzt wird, wobei die Viskosität der monomeren Flüssigkeit bzw. der Lösung derart gering ist, daß das im nachfolgenden Arbeitsgang aufzubringende vorgehärtete Pulver des Kunststoffes der zweiten Schicht daran kleben bleibt. Um diese Klebefähigkeit zu gewährleisten, kann die Viskosität der ersten, als Flüssigkeit aufzubringenden Schicht durch Lösungsmittelzusätze, Erwärmen, usw. auf den für das Auftragsverfahren günstigsten Wert eingestellt werden, d.h. die Viskosität der ersten Schicht muß einerseits niedrig genug sein, damit das Pulver der zweiten Schicht anhaftet, andererseits so hoch, daß das anhaftende Pulver nicht auf der ersten Schicht abgleitet. Es ist anhand von einfachen Versuchen ohne weiteres möglich, die für den jeweiligen Fall günstigste Viskosität zu bestimmen.

Es ist auch möglich, daß die Viskosität der zuerst aufgebrachten Schicht nach dem Auftragen durch eine Wärmebehandlung oder durch Absaugung des Lösungsmittels usw. auf den die Klebefähigkeit gewährleistenden Wert gebracht wird.

Die Dicke der ersten Schicht kann beispielsweise auch auf mechanischem Weg, z.B. durch Abstreifen, Glätten oder Abbürsten vor dem Aufbringen der zweiten Schicht auf den gewünschten Wert von 0,1 bis 1 mm gebracht werden.

Das Aufbringen des vorgehärteten pulverförmigen Kunststoffes der zweiten Schicht geschieht nach an sich bekannten Verfahren, beispielsweise nach dem oben als bekannt herausgestellten Wirbelschichtverfahren (Fließbettverfahren). Es ist auch möglich, das vorgehärtete Pulver auf die gesamte Oberfläche der ersten Schicht oder auch nur auf Teile davon aufzutragen, indem dieses Pulver aus einer Düse aufgestäubt wird.

Nach dem Aufbringen des vorgehärteten Pulvers der zweiten Schicht wird das Bauelement zum gemeinsamen Aushärten der beiden übereinander liegenden Schichten einer den verwendeten Umhüllmaterialien angepaßten Wärmebehandlung zugeführt. Bei dieser Wärmebehandlung muß die Temperatur einerseits anfangs so niedrig bleiben, daß die kombinierte Schicht nicht abtropft, andererseits muß aber später, d.h. nach einer ausreichenden Verfestigung der Unterschicht, die Temperatur so angehoben werden, daß die pulverförmige Oberschicht schmilzt und daß beide Schichten innerhalb der zur Verfügung stehenden Zeit aushärten.

Als aushärtbares Harz in Pulverform wird vorzugsweise vorgehärtetes Epoxidharzpulver verwendet. Ein solches Pulvermaterial wird z.B. von der Fa. Hysol unter der Bezeichnung DK 1805 angeboten.

Im übrigen richtet sich die Auswahl der aufzutragenden Kunststoffmaterialien nach den oben angeführten Bedingungen für die Eigenschaften der Umhüllungsschicht. Für die auf dem Markt befindlichen Kunststoffmaterialien geben die Hersteller bezüglich dieser Forderungen eindeutige Spezifikationen.

Die Erfindung bietet darüber hinaus die Möglichkeit, ein elektrisches Bauelement nur teilweise zu umhüllen, wobei die Oberfläche gegebenenfalls nur an den gewünschten Stellen mit der ersten Schicht bedeckt wird und nach dem Auftragen der zweiten Schicht z.B. durch Abblasen das Pulver an den Stellen entfernt wird, wo es nicht durch die Klebewirkung der ersten Schicht festgehalten wird. Dieser Effekt kann auch erreicht werden, wenn die Gesamtoberfläche des Bauelementes mit der ersten Schicht bedeckt wird und diese anschließend wie.-der teilweise entfernt wird, z.B. durch Wischen, Waschen usw. Darüberhinaus besteht die Möglichkeit, daß das Bauelement vollständig mit der ersten Schicht und nur teilweise mit der zweiten Schicht umhüllt wird, wenn man nach dem Aufbringen der ersten Schicht diese in einen Teil der Oberfläche soweit aushärtet , daß sie keine Klebewirkung mehr hat. Nach dem ganzflächigen Aufbringen der zweiten Schicht wird beim Absaugen diese zweite pulverförmige Schicht an den Stellen ohne Klebewirkung entfernt.

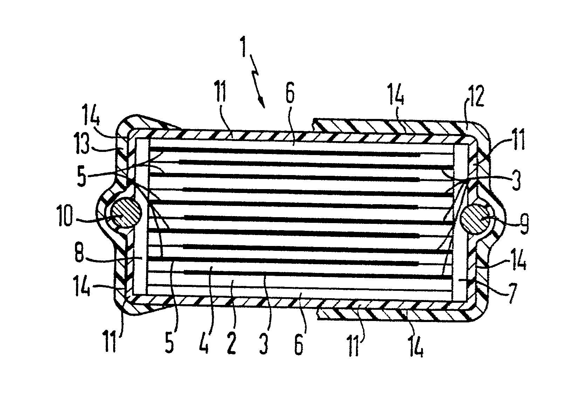

Anhand der beigefügten Zeichnung wird die Erfindung erläutert.

Es handelt sich bei dieser Zeichnung um die bevorzugte
Ausführungsform der Erfindung, nämlich um einen elektrischen Kondensator in Schichtbauweise. Das elektrische Bauelement 1 besteht aus den Dielektrikumsfolien 2 und
4, die mit Belegungen aus regenerierfähig dünnen Metallschichten 3 und 5, z.B. aus Aluminium, versehen sind.
Den Abschluß des Stapels bilden oben und unten Deckfolien 6. Die Schoopschicht 7 aus Aluminium und lötfähigem Weißmetall (Blei-Zinn-Legierung) dient zur elektrischen Kontaktierung der in der Figur nach rechts geführten Belegungen 3, während die Schoopschicht 8, ebenfalls
aus Aluminium und lötfähigem Weißmetall zur elektrischen
Kontaktierung der nach links geführten Belegungen 5 dient.
An die Schoopschichten 7 und 8 sind Stromzuführungsdrähte 9 und 10 befestigt, beispielsweise angeschweißt oder
angelötet. Diese Stromzuführungsdrähte können vorhanden
sein, wenn es sich bei dem Bauelement um ein solches
handelt, dessen Stromzuführungen in die Kontaktierungslöcher von Leiterplatten eingesetzt werden. Bei sog.
Chip-Ausführungsformen von Kondensatoren entfallen diese Stromzuführungsdrähte 9 und 10.

Die Schicht 11 aus Kunststoff umgibt im vorliegenden
Beispiel das gesamte Bauelement und ist durch Tauchen,
Sprühen, Rollen als dünnflüssiges Monomeres oder als
dünnflüssige Lösung aufgebracht.

Die Schicht 12 aus Kunststoff, die aus Gründen der
Vereinfachung nur auf der rechten Seite der Fig. dargestellt ist, ist oberhalb der Kunststoffschicht 11
angebracht, umgibt das gesamte Bauelement 1 und ist
durch Aufstäuben, im Fließbettverfahren oder ähnlichem
des vorgehärteten pulverförmigen Kunststoffes auf die noch feuchte Kunststoffschicht 11 aufgebracht.

Die Schicht 13 aus Kunststoff ist nur auf dem linken Teil der Figur dargestellt und entspricht im übrigen aber der Schicht 12, jedoch mit dem Unterschied, daß sie nur im Bereich der stirnseitigen Schoopschicht 8 und daran angrenzenden Bereichen des Kondensators aufgebracht ist.

In der Praxis wird entweder nur eine vollständige Umhüllungsschicht 12 oder es werden zwei Teilumhüllungsschichten 13 in den Bereichen der Schoopschichten 7 und 8 eingesetzt.

Zwischen den Schichten 12 bzw. 13 und der Schicht 11 befindet sich eine Übergangszone 14, die durch gemeinsame Aushärtung der Kunststoffe dieser beiden Schichten entstanden ist.

Bezugszeichenliste

1 elektrisches Bauelement, hier ein Kondensator in Stapel- bzw. Schichtbauweise
2 Dielektrikumsfolien,
3 Belegungen auf den Dielektrikumsfolien 2 aus regenerierfähig dünnen Metallschichten, z.B. Aluminium,
4 Dielektrikumsfolien,
5 Belegungen auf den Dielektrikumsfolien 4 aus regenerierfähig dünnen Metallschichten, z.B. Aluminium,
6 Deckfolien,
7 Schoopschicht aus Aluminium und leitfähigem Weißmetall (PB-Sn-Legierung) zur elektrischen Kontaktierung der Belegungen 3,
8 Schoopschicht aus Aluminium und lötfähigem Weißmetall (PB-Sn-Legierung) zur elektrischen Kontaktierung der Belegungen 5,

9 Stromzuführungsdraht, an der Schoopschicht 7 befestigt,

10 Stromzuführungsdraht, an der Schoopschicht 8 befestigt,

11 Kunststoffschicht, die das gesamte Bauelement 1 umgibt und durch Tauchen, Sprühen, Rollen als dünnflüssiges Monomeres oder als dünnflüssige Lösung aufgebracht ist,

12 Kunststoffschicht, die oberhalb der Kunststoffschicht 11 angebracht ist, das gesamte Bauelement 1 umgibt und durch Aufstäuben, im Fließbettverfahren oder ähnlichem des vorgehärteten pulverförmigen Kunststoffes auf die noch feuchte, klebrige Kunststoffschicht 11 aufgebracht ist,

13 Kunststoffschicht wie 12, die jedoch nur im Bereich der stirnseitigen Schoopschichten 7 und 8 aufgebracht ist,

14 Übergangszone zwischen den Kunststoffschichten 11 und 12 bzw. 13, entstanden durch gemeinsame Aushärtung

2 Patentansprüche
1 Figur

## Patentansprüche

1. Elektrisches Bauelement, das mit einer aus zwei Schichten bestehenden, mechanisch festen, feuchtedichten, wärmebeständigen, chemikalienresistenten und isolierenden Umhüllung aus ausgehärteten Kunststoffen vollständig oder teilweise umgeben ist, d a d u r c h  g e - k e n n z e i c h n e t,  daß die dem Bauelement (1) benachbarte erste Schicht (11) relativ dünn (0,1 - 1 mm) ist und aus wärmegehärtetem Kunststoff, insbesondere Epoxidharz, besteht, daß die außenliegende zweite Schicht (12, 13) ebenfalls aus wärmegehärtetem Kunststoff, insbesondere Epoxidharz, besteht, der in Form von vorgehärtetem Pulver auf die erste Schicht (11) vor deren Aushärtung aufgetragen ist, und daß zwischen erster Schicht (11) und zweiter Schicht (12 bzw. 13) eine durch gemeinsame Aushärtung der Kunststoffe beider Schichten (11 und 12 bzw. 13) gebildete Übergangszone (14) vorhanden ist.

2. Verfahren zum Herstellen eines umhüllten elektrischen Bauelements nach Anspruch 1, bei dem das Bauelement (1) zunächst durch Tauchen, Sprühen, Bestreichen (Rollen) mit der ersten Kunststoffschicht (11) versehen und darauf dann die zweite Kunststoffschicht (12 bzw. 13) aufgetragen wird, d a d u r c h  g e k e n n - z e i c h n e t,  daß die aufzutragende erste Schicht (11) erzeugt wird, indem der Kunststoff der ersten Schicht (11) als Monomeres oder als Lösung eingesetzt wird, wobei die Viskosität gerade so gering ist, daß daran das Pulver des Kunststoffes der zweiten Schicht (12 bzw. 13) klebt (haftet), jedoch ein Abtropfen nicht eintritt, und daß die aufzutragende zweite Schicht (12 bzw.13) erzeugt wird, indem vorgehärtetes Pulver des Kunststoffes der zweiten Schicht (12 bzw. 13) aufgestäubt oder im Fließbettverfahren auf die vorgesehenen Oberflächenteile der ersten Schicht (11) aufgetragen wird, und daß danach beide Kunststoffschichten (11 und 12 bzw. 13) in einem Arbeitsgang vollständig ausgehärtet werden.

0169403